# EUROPEAN PATENT SPECIFICATION

(11) **EP 1 938 448 B1**
(45) Date of publication and mention of the grant of the patent: **29.07.2015**
(21) Application number: 05788688.9
(22) Date of filing: 27.09.2005
(51) Int. Cl.: H03B 5/24, H03B 5/12

(54) **AN OSCILLATOR CIRCUIT**
OSZILLATORSCHALTUNG
CIRCUITS OSCILLANTS

(43) Date of publication of application: 02.07.2008
(73) Proprietor: Telefonaktiebolaget L M Ericsson (publ), 164 83 Stockholm (SE)
(72) Inventor: ASPEMYR, Lars, S-434 40 Kungsbacka (SE); JACOBSSON, Harald, S-426 74 Västra Frölunda (SE)
(74) Representative: Ericsson
(86) International application number: PCT/SE2005/001429
(87) International publication number: WO 2007/037724

(56) References cited:
- EP-A1- 1 496 609
- WO-A1-95/34951
- US-A- 5 900 788
- US-A- 6 064 277
- US-A1- 2003 210 101
- US-A1- 2004 070 461
- US-A1- 2005 186 930
- US-B1- 6 750 726
- US-B1- 6 859 109
- HAJIMIRI A ET AL: 'Design Issues in CMOS Diferential LC Oscillators.' IEEE JOURNAL OF SOLID STATE CIRCIUTS. vol. 34, no. 5, May 1999, pages 717 - 724, XP000908586

## Description

### TECHNICAL FIELD OF THE INVENTION

The present invention relates to an oscillating electrical circuit having multiple loops.

### BACKGROUND OF THE INVENTION

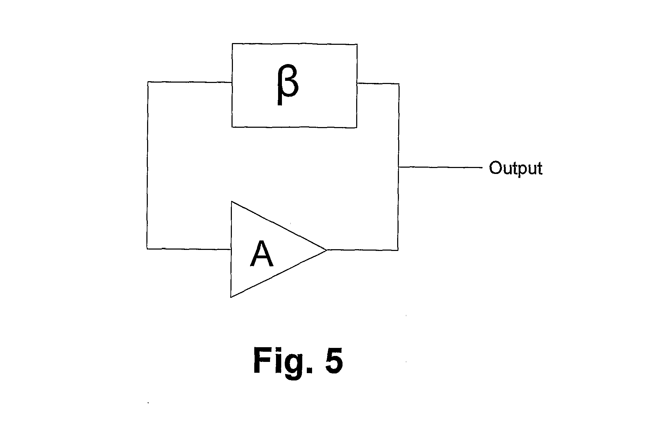

The basic concept of a single ended oscillator comprising an active element A and the feedback element β is illustrated in Fig. 5. To start and maintain an oscillation in an electrical oscillator, normally the output of an active element is fed back to the input of the active device by a feedback network, which creates a loop-gain larger than one. The feedback elements have normally narrow-band characteristics. Moreover, the oscillation frequency for the oscillator may be varied by electrically controlling the centre frequency for the feedback element.

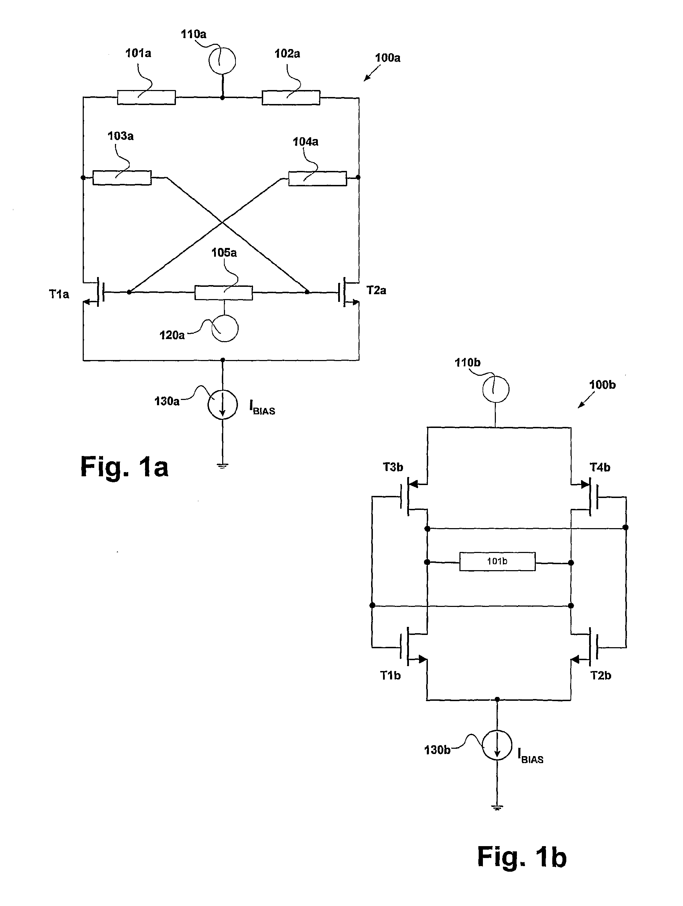

This is further illustrated in Figs. 1 a and 1b for a differential realisation. To create an oscillator with low phase noise, fast switching of the active device(s) is/are advantageous. Moreover, the relation in time between the current injected by the active device into the resonant element and the voltage over the resonant element, as in Fig. 1a, is important if low phase noise is required.

To achieve fast switching, the loop-gain may be increased by increasing the gain of the active device either by having a wider device, which is valid in the case of FET (Field Effect Transistor), or by increasing the bias current for the active device. However, increasing the power consumption is not desired and wider transistors will result in more parasitic capacitance, which counteracts fast switching. Moreover, it is not possible to control the phase of the injected current pulse in an optimal way with the common oscillator topologies shown in Figs. 1 a and 1b.

In Fig. 1a, the oscillator circuit 100a comprises two resonant elements 101a and 102a, which at a common terminal are fed from a supply voltage 110a and connected to the drains and gates of transistors T1 a and T2a, respectively. Feedback element 103a is connected between the drain of transistor T1a and gate of transistor T2a and feedback element 104a is connected between the drain of T2a and gate of transistor T1a. Optionally, a voltage bias source 120a may be connected to the gates of the transistors T1 a and T2a via an impedance element 105a. The sources of the transistors are AC grounded, optionally through a current bias source 130a.

Fig. 1b illustrates another oscillator circuit 100b in which a resonant element 101 b is connected to the drains of active elements T1 b and T2b. Active elements comprising two transistors T3b and T4b are connected with gate and drain common to T1 b and T2b, respectively. The drain of T3b is connected to the common gates of T4b and T2b while the drain of T4b is connected to the common gates of T3b and T1 b, constituting the feedback. The circuit is fed with a supply voltage 110b through the sources of T3b and T4b. The sources of transistors T1b and T2b are grounded, optionally through a current bias source 130b.

It is also possible to provide additional feedback elements in the circuit according to Fig. 1 b. Moreover, the current source can be provided on top of the circuit.

Prior art according to "Design Issues in CMOS Differential LC Oscillators", by A. Hajimiri et al, IEEE journal of Solid State Circuits, Vol. 34, No. 5, May 1999, discloses a topology for oscillators, in which fast switching and current pulse optimisation is achieved. However, this document is silence about the novel connection according to the present invention.

US 5,900,788 concerns a low-noise oscillator circuit with an amplifier element connected for feedback, to which amplifier element a resonator, e.g. a resonant circuit, is coupled, in which oscillator circuit, in addition to a positive feedback of the amplifier for the oscillation generation, a negative feedback loop between the output and the input of the amplifier element is provided for. The amplifier element serves to compensate losses in the resonator and to provide the power to be coupled out. This document suggests introduction of a "negative feedback". A high impedance load is not mentioned.

US 2005/186930 relates to a transceiver with a receiver, a transmitter, a local oscillator (LO) generator, a controller, and a self-testing unit. The invention comprises a phase lock loop, comprising an oscillator having a tuning input, and an output with a tunable frequency responsive to the tuning input; a subsampling mixer to mix the oscillator output with a second signal to produce a mixed signal; and a phase detector outputting an error signal which is a function of a phase difference between the mixed signal and an input signal, the error signal being applied to the tuning point. No references to a positive feedback loop and a high impedance load are made.

US 6,750,726 relates to oscillator circuit including an electrical load, a first MOS device, a second MOS device, and a negative feedback circuit. The electrical load is coupled between a first node and a second node. The first MOS device is coupled between the first node and a third node, and controls a first current flowing from the first node to the third node. The second MOS device is coupled between the second node and a fourth node, and controls a second current flowing from the second node to the fourth node. A positive feedback circuit is formed with the first and second MOS devices. The positive feedback circuit has inputs from the first and second nodes and outputs to the first and second MOS devices. The negative feedback circuit has inputs from the third and fourth nodes and outs to the first and second MOS devices. This invention provides a voltage-controlled oscillator (VCO) having intrinsically low close-in phase noise. Accordingly, no additional positive feedback loops are used but the entire circuit is a positive feedback loop. Moreover, the solution lacks a high impedance load, which provides extra voltage gain despite a low current consumption.

US 6,859,109 relates to a phase-locked loop (PLL) having an analog divider in the feedback path that receives either the in-phase or quadrature-phase pair of outputs from a voltage-controlled oscillator (VCO) while the other pair, 90-degree out-of-phase, of outputs from the VCO is used for the PLL output. Phases between the PLL's input and output are inherently aligned. The analog output of the analog divider is converted to a digital clock signal and applied to a cascade of digital dividers to generate a reduced feedback clock. The reduced feedback clock is applied to the D input and the digital clock signal is applied to the clock input of a pseudo D-flip-flop that drives the feedback input of a phase-frequency detector that drives the charge pump to the VCO input. Another cascade of digital dividers and pseudo D-flip-flop re-align the reference clock input to the phase-frequency detector. This document is silent of using a positive feedback loop and a high impedance load.

EP 1 496 609 discloses a circuit for a voltage controlled oscillator (VCO) having a timing control by a bias circuitry and having a low phase-noise. The VCO has a single inductor (VCO-1 L).

US 2003/210101 discloses a MEMS-based, clock generation circuit for generating a highly stable, digital output signal without the need for external components. The circuit comprises a substrate. The circuit comprises an oscillator fabricated on the substrate and including a high-Q MEMS LC-tank apparatus for generating a periodic signal. Furthermore, the circuit comprises a first circuitry also fabricated on the substrate for converting the periodic signal into a high frequency digital output signal.

US 6 064 277 discloses a drive circuit for an oscillator having an LC tank reduces phase noise by maximizing the oscillation amplitude and minimizing the drive to the tank. The drive circuit utilizes a capacitive attenuator network for level shifting the oscillation signal before feeding it back to the drive transistors in the drive circuit, thereby allowing a large peak voltage swing across the tank without saturating the transistors. An adaptive control circuit controls the biasing of the drive transistors and reduces the drive to the tank when the maximum oscillation amplitude is reached so that the drive circuit replenishes just the minimum amount of energy lost in the tank during each cycle, thereby minimizing the coupling of active circuit noise into the tank

### SUMMARY OF THE INVENTION

The objects of the present invention are to provide an oscillator with fast switching characteristics and current pulse optimisation. The presented invention allows realization in a very compact (and low parasitic) way. The characteristics will further allow very high frequency VCOs based on this topology.

Thus, the invention according to a preferred embodiment will provide a faster or/and more optimised switching resulting in lower oscillator phase noise for a fixed bias current.

In the preferred embodiment, the current between the source node and the ground obtains a lower amplitude for its DC component.

For these reasons an oscillator circuit according to the independent claim 1 is provided.

The additional element may also be provided with supplementary amplification.

According to the invention, the oscillator circuit further comprises: two resonant elements, having a first common terminal fed from a supply voltage and second terminals connected to the drains of first and second transistors, respectively provided as active elements, feedback elements connected between the drain of the first transistor and gate of the second transistor, and a feedback for each transistor comprising the phase shifting element. Preferably, the feedback comprises an amplifier and inverter networks connected between drain and gate of the first and second transistor, respectively. The sources of the transistors may be connected to ground through one of directly, a current bias source, via a resistor, impeditive element or current generator. A voltage bias network may be connected to gates of the first and second transistors.

According to a second embodiment, the oscillator circuit comprises: a first transistor pair, a second transistor pair, a resonant element arranged connected to the drains of a first and a second active element pair, first and second active element pair, each transistor pair has gate and drain connected, wherein a drain of a first transistor in the transistor pair is connected to gate common of a second transistor in the transistor pair, a supply voltage source connected to the sources of the first and second transistors, and additional feedback elements connected between the drains and gates of the active elements.

The resonant elements may comprise one or several of LC circuits and the feedback elements may comprise capacitors or transformers.

The additional feedback loops may comprise transistors having their gates connected to the drains of the same transistors, respectively, and their outputs (drain) connected to the gates of transistors. A bias voltage is applied to the sources of the feedback transistors.

Preferably, the feedback loop comprises an inverter network and/or an amplifier.

The invention also relates to a method of providing an oscillator with fast switching characteristics and current pulse optimization according to the independent claim 10. The invention also relates to an electrical circuit comprising an oscillator as mentioned above.

### BRIEF DESCRIPTION OF THE DRAWINGS

In the following, the invention will be further described in a non-limiting way with reference to the accompanying drawings, in which:
- Figs. 1a and 1b: schematically illustrate electrical circuits with oscillator topologies according to prior art,
- Fig. 2a: schematically illustrates an electrical circuit with an oscillator topology according to the basic concept of the present invention corresponding to the circuit illustrated in FIG. 1a, FIG. 2b schematically illustrates an electrical circuit with an oscillator topology corresponding to the circuit illustrated in FIG. 1b,
- Fig. 3: is a schematic diagram illustrating a third embodiment of the invention,
- Fig. 4: is a schematic diagram illustrating a fourth embodiment of the invention,
- Fig. 5: is a basic oscillator concept,
- Fig. 6: illustrates the source to ground current graph based on one embodiment of the invention, and
- Fig. 7: illustrates a graph of phase noise characteristics, based on one embodiment of the invention.

### DETAILED DESCRIPTION OF THE EMBODIMENTS

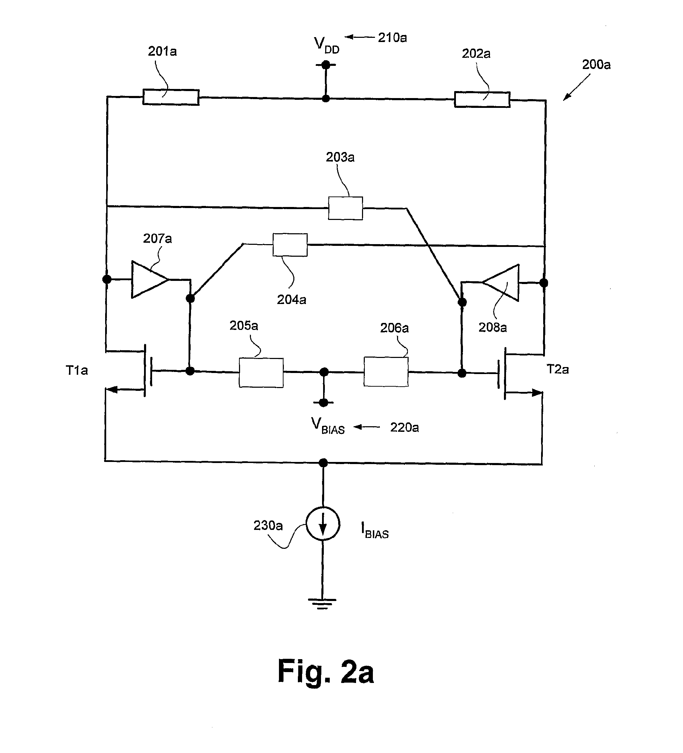

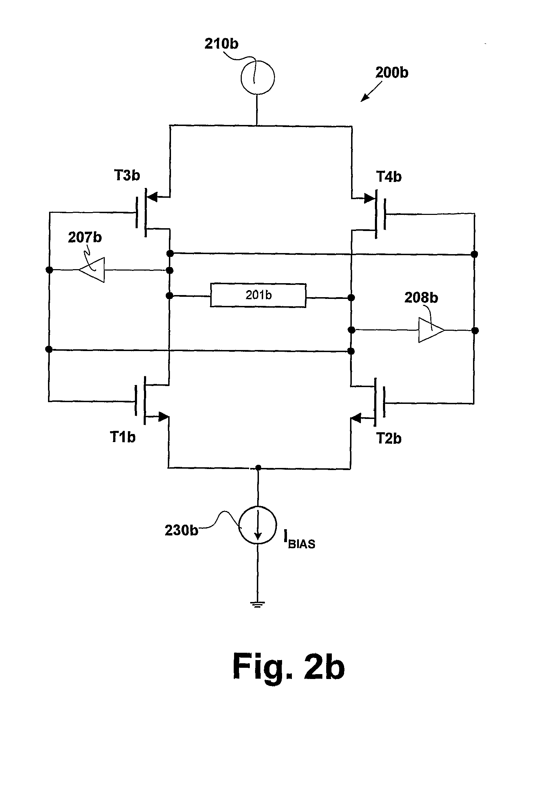

According to the invention, the circuits according to Figs. 1 a and 1 b are modified and comprise additional positive feed-back loops with a device having variable gain and variable phase characteristics. By this optimisation a lowered phase noise for the oscillator can be achieved. The active device in the added loop will have a high impedance load, which provides extra voltage gain despite a low current consumption. This is illustrated in Figs. 2a and 2b.

Thus, Fig. 2a illustrates an oscillator circuit 200a, according to one exemplary embodiment of the present invention, comprising two resonant elements 201 a and 202a, which at a common terminal are fed from a supply voltage 210a (V_{DD}) and connected to the drains of transistors T1a and T2a, respectively. Feedback elements 203a and 204a are connected in series between the drain of one of the transistors to the gate of each other transistor and vice versa. A voltage bias network comprising a source 220a feeding common terminals of, e.g. impedance elements 205a and 206a is connected to the gates of the transistors T1 a and T2a. The sources of the transistors are optionally grounded through a current bias source 230a. However, it may also be grounded directly, via a resistor, impeditive element or current generator. The feedback according to the invention comprises amplifier and inverter networks (circuits or elements) 207a and 208a connected between the drain and gate of each transistor T1 a and T2a, respectively. The essential characteristic of the feedback elements are phase shifting and amplification.

Even though active elements T1a and T2a are illustrated as MOS transistors, it is obvious that they may be substituted by any type of active elements. This is valid for all embodiments illustrated and described herein. Fig. 2b illustrates another oscillator circuit 200b, corresponding to the circuit of Fig. 1b, in which a resonant element 201 b is arranged connected to the drains of active elements T1 b and T2b, T3b and T4b. Two transistors T3b and T4b are connected with gate and drain common to T1 b and T2b, respectively. The drain of T3b is connected to the gates of T4b and T2b while the drain of T4b is connected to the gates of T3b and T1 b. The gate-drain connection between T1 b, T2b and T3b, T4b constitutes two feedback loops which allow the oscillator to oscillate. Again, there may be provided feedback elements in the feedback path. The circuit is fed with a supply voltage 210b through the sources of T3b and T4b. The sources of transistors T1b and T2b are grounded. The feedback elements 207b and 208b are connected between the output (drain) and gates of the active elements T1b, T2b, T3b and T4b. 207b and 208b provide the additional feedback loops. Thus, the active elements are connected in pairs and the two pairs are complementary. The circuit may also comprise grounded source.

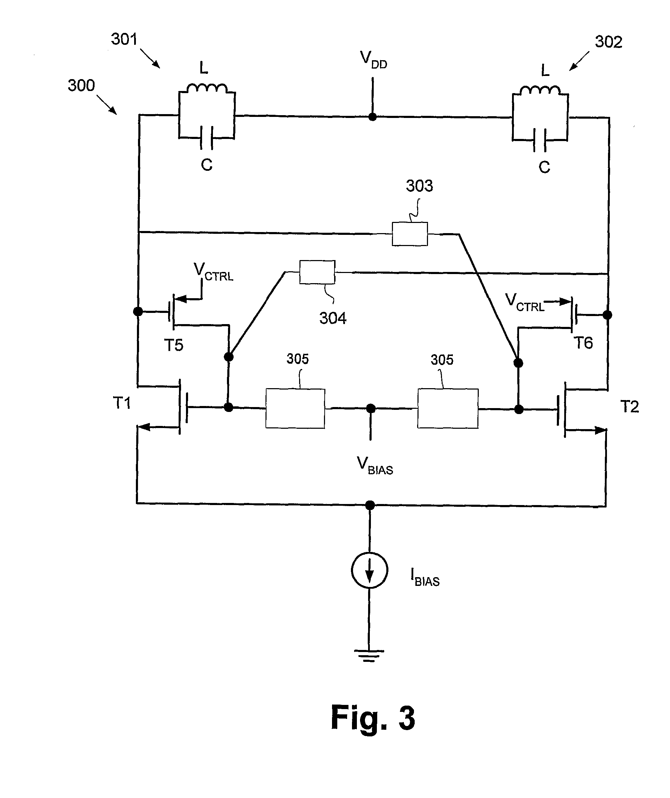

A more detailed exemplary implementation embodiment of the present invention is illustrated in Fig. 3. The resonant elements 301 and 302 comprise LC circuits. The feedback elements 303 and 304 may comprise transformers or other AC coupling elements. The additional positive feedbacks, according to the invention, comprise transistors T5 and T6 having their gates connected to the drains of the transistors T1 and T2, respectively, and their outputs (drain) connected to the gates of the transistors T1 and T2. A control voltage (V_{CTRL}) is applied to the sources of the feedback (PMOS) transistors T5 and T6. Element 305, which may be an inductor or other AC high impedance element, functions as a current generator with or without additional feedback loop.

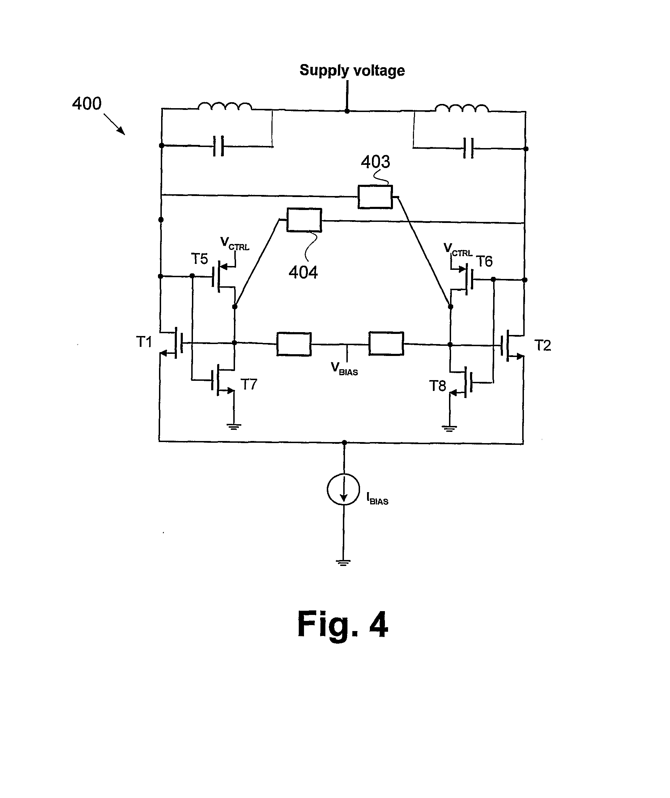

In a fourth exemplary embodiment as illustrated in Fig. 4, similar to the embodiment of Fig. 3, the feedback network comprises an inverter network comprising transistors T5, T6, T7 and T8, and feedback elements 403 and 404. The inverter network in this case comprises N-channel transistors T7 and T8 grounded at source and connected via drain to gates of T1 and T2 and drains of T5 and T6, respectively.

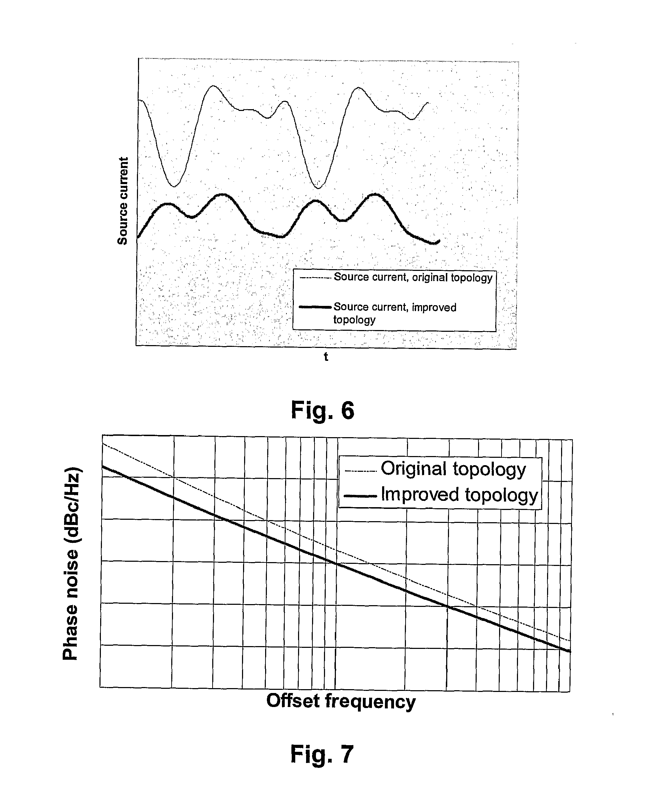

To verify the functionality of a circuit according to the present invention some simulations have been carried out. The graph of Fig. 6 illustrates the source to ground current in an oscillator according to Fig. 3, a major difference in current amplitude and the improved current waveform can be observed. A lower current consumption is apparent. Both AC- and DC-components of the current has been reduced. This is due to the enhanced switching and current waveform. In the graph, the dashed line shows the source current time dependency of an ordinary oscillator and the continuous line the source current time dependency of a circuit according to the present invention. It should be noted that both the prior art topology and the embodiment according to the invention provide substantially the same phase noise performance but the power consumption, which is proportional to the mean value of the source to ground current is much lower for the embodiment according to the invention.

In the simulated topology, the transistors are assumed as: NMOS 100 µm/0.1 µm (W/L = 1000) and PMOS 50 µm/0.1 µm (W/L 500).

Fig. 7 illustrates a graph of optimum phase noise performance for the given topology, both with and without the extra feedback loop. In the graph, the dashed line shows the phase noise versus offset frequency of an ordinary oscillator and the continuous line the phase noise versus offset frequency of a circuit according to the present invention. The improved performance does not come with increased power consumption.

The oscillator of the invention may be used for any frequencies and within for example radio and communication applications.

The invention is not limited to the shown embodiments but can be varied in a number of ways without departing from the scope of the appended claims; the arrangement and the method can be implemented in various ways using different technologies depending on application, functional units, needs and requirements etc.

## Claims

1. An oscillator circuit (200a, 300, 400) comprising two resonant elements (201 a, 202a) fed from a supply voltage (210a, 210b), an active element (T1b, T2a) and a feedback loop,
wherein the oscillator circuit (200a, 300, 400) further comprises an additional positive feedback loop with a phase shifting element (207a, 208a) having variable gain and variable phase characteristics,
said feedback loop is connected to a gate of said active element (T1b, T2a) and
the two resonant elements (201 a, 202a),
said additional positive feedback loop is connected between the drain and the gate of said active element (T1a, T2a)
wherein the two resonant elements (201 a, 202a) have a first common terminal fed from a supply voltage (210a) and second terminals connected to the drains of first and second transistors (T1 a, T2a), respectively,
wherein the active element comprises the first and second transistors (T1 a, T2a),
wherein the oscillator circuit (200a, 300, 400) further comprises:
- one feedback element (203a) connected between said drain of said first transistor (T1a) and a gate of said second transistor (T2a), and
- an additional feedback element (204a) connected between said drain of said second transistor (T2a) and a gate of said first transistor (T1 a),
wherein the phase shifting element comprises feedback transistors (T5, T6) having their gates connected to the drains of the first and second transistors (T1, T2), respectively, and their outputs connected to the gates of the first and second transistors (T1, T2), respectively, **characterized in that**
a bias voltage (V_{bias}) is applied to the sources of the feedback transistors (T5, T6) via high impedance loads (205a, 206a, 305).

2. The oscillator circuit of claim 1, wherein said feedback elements comprises an amplifier and inverter networks connected between drain and gate of said first and second transistor (T1 a, T2a), respectively.

3. The oscillator circuit of claim 1 or 2, wherein sources of the transistors are grounded directly or connected to ground through one of a current bias source (230a), via a resistor, an impedance element or a current generator.

4. The oscillator circuit according to any of claims 1 to 3, comprising a voltage bias network (220a) connected to gates of said first and second transistors (T1 a, T2a).

5. The oscillator circuit of claim 1, wherein the resonant element comprises one or several LC circuits.

6. The oscillator circuit of claim 1, wherein the oscillator circuit (200a) comprises feedback elements, and wherein the feedback elements comprise capacitors or transformers.

7. The oscillator circuit of claim 1, wherein the feedback loop comprises an inverter network.

8. The oscillator circuit of claim 1, wherein said feedback loop comprises an amplifier.

9. A method of providing an oscillator with fast switching characteristics and current pulse optimization, the method comprising the steps of:
- arranging an oscillator circuit (200a, 300, 400) with two resonant elements (201 a, 202a) fed from a supply voltage (210a, 210b), an active element (T1a, T2a) and a feedback loop, and
- providing said oscillator circuit (200a, 300, 400) with an additional positive feedback loop with a phase shifting element (207a, 208a) having variable gain and variable phase characteristics, said feedback loop is connected to a gate of said active element (T1a, T2a) and the two resonant elements (201a, 202a), and said additional feedback loop is connected between the drain and the gate of said active element (T1a, T2a) wherein the two resonant elements (201 a, 202a) have a first common terminal fed from a supply voltage (210a) and second terminals connected to the drains of first and second transistors (T1 a, T2a), respectively,
wherein the active element comprises the first and second transistors (T1 a, T2a),
wherein the oscillator circuit (200a, 300, 400) further comprises:
- one feedback element (203a) connected between said drain of said first transistor (T1a) and a gate of said second transistor (T2a), and
- an additional feedback element (204a) connected between said drain of said second transistor (T2a) and a gate of said first transistor (T1 a),
wherein the phase shifting element comprises feedback transistors (T5, T6) having their gates connected to the drains of the first and second transistors (T1, T2), respectively, and their outputs connected to the gates of the first and second transistors (T1, T2), respectively, **characterized in that**
a bias voltage (V_{bias}) is applied to the sources of the feedback transistors (T5, T6) via high impedance loads (205a, 206a, 305).

10. An electrical circuit comprising an oscillator circuit according to any of claims 1-8.

## Patentansprüche

1. Oszillatorschaltung (200a, 300, 400), Folgendes umfassend: zwei Resonanzelemente (201a, 202a), die von einer Versorgungsspannung (210a, 210b) gespeist werden, ein aktives Element (T1b, T2a) und eine Feedbackschleife;
worin die Oszillatorschaltung (200a, 300, 400) außerdem eine zusätzliche positive Feedbackschleife mit einem Phasenverschiebungselement (207a, 208a) mit variabler Verstärkung und variablen Phasencharakteristiken umfasst,
wobei die Feedbackschleife an ein Gate des aktiven Elements (T1b, T2a) und die zwei Resonanzelemente (201a, 202a) angeschlossen ist,
wobei die zusätzliche positive Feedbackschleife zwischen dem Drain und dem Gate des aktiven Elements (T1a, T2a) angeschlossen ist,
worin die zwei Resonanzelemente (201a, 202a) ein erstes gemeinsames Endgerät haben, das von einer Versorgungsspannung (210a) gespeist wird, und zweite Endgeräte, die an die Drains vom ersten bzw. zweiten Transistor (T1a, T2a) angeschlossen sind,
worin das aktive Element den ersten und zweiten Transistor (T1a, T2a) umfasst, worin die Oszillatorschaltung (200a, 300, 400) außerdem umfasst:
- ein Feedbackelement (203a), das zwischen dem Drain des ersten Transistors (T1a) und einem Gate des zweiten Transistors (T2a) angeschlossen ist, und
- ein zusätzliches Feedbackelement (204a), das zwischen dem Drain des zweiten Transistors (T2a) und einem Gate des ersten Transistors (T1a) angeschlossen ist,
worin das Phasenverschiebungselement Feedbacktransistoren (T5, T6) umfasst, deren Gates an die Drains des ersten und zweiten Transistors (T1, T2) angeschlossen sind und deren Ausgänge an die Gates des ersten und zweiten Transistors (T1, T2) angeschlossen sind,
**dadurch gekennzeichnet, dass**
eine Bias-Spannung (V_{bias}) an die Sources der Feedbacktransistoren (T5, T6) über Hochimpedanz-Lasten (205a, 206a, 305) angelegt ist.

2. Oszillatorschaltung nach Anspruch 1, worin die Feedbackelemente einen Verstärker und Inverternetze umfassen, die zwischen Drain und Gate des ersten bzw. zweiten Transistors (T1a, T2a) angeschlossen sind.

3. Oszillatorschaltung nach Anspruch 1 oder 2, worin Sources der Transistoren direkt geerdet sind oder durch eins von Folgenden an Erde angeschlossen sind: eine Strom-Bias-Source (230a), über einen Widerstand, ein Impedanz-Element oder einen Stromgenerator.

4. Oszillatorschaltung nach einem der Ansprüche 1 bis 3, ein Spannungs-Bias-Netz (220a) umfassend, das an Gates des ersten und zweiten Transistors (T1a, T2a) angeschlossen ist.

5. Oszillatorschaltung nach Anspruch 1, worin das Resonanzelement einen oder mehrere Schwingkreise umfasst.

6. Oszillatorschaltung nach Anspruch 1, worin die Oszillatorschaltung (200a) Feedbackelemente umfasst und worin die Feedbackelemente Kondensatoren oder Transformatoren umfassen.

7. Oszillatorschaltung nach Anspruch 1, worin die Feedbackschleife ein Inverternetz umfasst.

8. Oszillatorschaltung nach Anspruch 1, worin die Feedbackschleife einen Verstärker umfasst.

9. Verfahren zum Bereitstellen eines Oszillators mit schnellen Schaltcharakteristiken und Strompulsoptimierung, wobei das Verfahren die folgenden Schritte umfasst:
- Anordnen einer Oszillatorschaltung (200a, 300, 400) mit zwei Resonanzelementen (201a, 202a), die von einer Versorgungsspannung (210a, 210b) gespeist werden, einem aktiven Element (T1a, T2a) und einer Feedbackschleife, und
- Bereitstellen der Oszillatorschaltung (200a, 300, 400) mit einer zusätzlichen positiven Feedbackschleife mit einem Phasenverschiebungselement (207a, 208a) mit variabler Verstärkung und variablen Phasencharakteustiken, wobei die Feedbackschleife an ein Gate des aktiven Elements (T1a, T2a) und die zwei Resonanzelemente (201a, 202a) angeschlossen ist und die zusätzliche Feedbackschleife zwischen dem Drain und dem Gate des aktiven Elements (T1a, T2a) angeschlossen ist, worin die zwei Resonanzelemente (201a, 202a) ein erstes gemeinsames Endgerät haben, das von einer Versorgungsspannung (210a) gespeist wird, und zweite Endgeräte, die an die Drains vom ersten bzw. zweiten Transistor (T1a, T2a) angeschlossen sind, worin das aktive Element den ersten und zweiten Transistor (T1a, T2a) umfasst, worin die Oszillatorschaltung (200a, 300, 400) außerdem umfasst:
- ein Feedbackelement (203a), das zwischen dem Drain des ersten Transistors (T1a) und einem Gate des zweiten Transistors (T2a) angeschlossen ist, und
- ein zusätzliches Feedbackelement (204a), das zwischen dem Drain des zweiten Transistors (T2a) und einem Gate des ersten Transistors (T1a) angeschlossen ist, worin das Phasenverschiebungselement Feedbacktransistoren (T5, T6) umfasst, deren Gates an die Drains des ersten und zweiten Transistors (T1, T2) angeschlossen sind und deren Ausgänge an die Gates des ersten und zweiten Transistors (T1, T2) angeschlossen sind,
**dadurch gekennzeichnet, dass**
eine Bias-Spannung (V_{bias}) an die Sources der Feedbacktransistoren (T5, T6) über Hochimpedanz-Lasten (205a, 206a, 305) angelegt ist.

10. Elektrische Schaltung, eine Oszillatorschaltung nach einem der Ansprüche 1-8 umfassend.

## Revendications

1. Circuit oscillant (200a, 300, 400) comprenant deux éléments résonants (201a, 202a) alimentés par une tension d'alimentation (210a, 210b), un élément actif (T1b, T2a) et une boucle de rétroaction,
dans lequel le circuit oscillant (200a, 300, 400) comprend en outre une boucle de rétroaction positive supplémentaire avec un élément de déphasage (207a, 208a) ayant des caractéristiques de gain variable et de phase variable,
ladite boucle de rétroaction est connectée à une grille dudit élément actif (T1b, T2a) et aux deux éléments résonants (201a, 202a),
ladite boucle de rétroaction positive supplémentaire est connectée entre le drain et la grille dudit élément actif (T1a, T2a),
dans lequel les deux éléments résonants (201a, 202a) ont une première borne commune alimentée par une tension d'alimentation (210a) et des deuxièmes bornes connectées aux drains de premier et deuxième transistors (T1a, T2a), respectivement,
dans lequel l'élément actif comprend les premier et deuxième transistors (T1a, T2a),
dans lequel le circuit oscillant (200a, 300, 400) comprend en outre :
- un élément de rétroaction (203a) connecté entre ledit drain dudit premier transistor (T1a) et une grille dudit deuxième transistor (T2a), et
- un élément de rétroaction supplémentaire (204a) connecté entre ledit drain dudit deuxième transistor (T2a) et une grille dudit premier transistor (T1a),
dans lequel l'élément de déphasage comprend des transistors de rétroaction (T5, T6) ayant leurs grilles connectées aux drains des premier et deuxième transistors (T1, T2), respectivement, et leurs sorties connectées aux grilles des premier et deuxième transistors (T1, T2), respectivement,
**caractérisé en ce que**
une tension de polarisation (V_{bias}) est appliquée aux sources des transistors de rétroaction (T5, T6) par l'intermédiaire de charges à haute impédance (205a, 206a, 305).

2. Circuit oscillant selon la revendication 1, dans lequel lesdits éléments de rétroaction comprennent un amplificateur et des réseaux d'inverseurs connectés entre le drain et la grille desdits premier et deuxième transistor (T1a, T2a), respectivement.

3. Circuit oscillant selon la revendication 1 ou 2, dans lequel les sources des transistors sont mises à la masse directement ou connectées à la masse par l'intermédiaire de l'une d'une source de polarisation en courant (230a), par l'intermédiaire d'une résistance, d'un élément d'impédance ou d'un générateur de courant.

4. Circuit oscillant selon l'une quelconque des revendications 1 à 3, comprenant un réseau de polarisation en tension (220a) connecté aux grilles desdits premier et deuxième transistors (T1a, T2a).

5. Circuit oscillant selon la revendication 1, dans lequel l'élément résonant comprend un ou plusieurs circuits LC.

6. Circuit oscillant selon la revendication 1, dans lequel le circuit oscillant (200a) comprend des éléments de rétroaction, et dans lequel les éléments de rétroaction comprennent des condensateurs ou des transformateurs.

7. Circuit oscillant selon la revendication 1, dans lequel la boucle de rétroaction comprend un réseau d'inverseurs.

8. Circuit oscillant selon la revendication 1, dans lequel ladite boucle de rétroaction comprend un amplificateur.

9. Procédé pour réaliser un oscillateur avec des caractéristiques de commutation rapide et une optimisation d'impulsion de courant, le procédé comprenant les étapes :
- d'agencement d'un circuit oscillant (200a, 300, 400) avec deux éléments résonants (201a, 202a) alimentés par une tension d'alimentation (210a, 210b), un élément actif (T1a, T2a) et une boucle de rétroaction, et
- de fourniture audit circuit oscillant (200a, 300, 400) d'une boucle de rétroaction positive supplémentaire avec un élément de déphasage (207a, 208a) ayant des caractéristiques de gain variable et de phase variable, ladite boucle de rétroaction étant connectée à une grille dudit élément actif (T1a, T2a) et aux deux éléments résonants (201a, 202a), et ladite boucle de rétroaction supplémentaire étant connectée entre le drain et la grille dudit élément actif (T1a, T2a),
dans lequel les deux éléments résonants (201a, 202a) ont une première borne commune alimentée par une tension d'alimentation (210a) et des deuxièmes bornes connectées aux drains des premier et deuxième transistors (T1a, T2a), respectivement,
dans lequel l'élément actif comprend les premier et deuxième transistors (T1a, T2a),
dans lequel le circuit oscillant (200a, 300, 400) comprend en outre :
- un élément de rétroaction (203a) connecté entre ledit drain dudit premier transistor (T1a) et une grille dudit deuxième transistor (T2a), et
- un élément de rétroaction supplémentaire (204a) connecté entre ledit drain dudit deuxième transistor (T2a) et une grille dudit premier transistor (T1a),
dans lequel l'élément de déphasage comprend des transistors de rétroaction (T5, T6) ayant leurs grilles connectées aux drains des premier et deuxième transistors (T1, T2), respectivement, et leurs sorties connectées aux grilles des premier et deuxième transistors (T1, T2), respectivement,
**caractérisé en ce que**
une tension de polarisation (V_{bias}) est appliquée aux sources des transistors de rétroaction (T5, T6) par l'intermédiaire de charges à haute impédance (205a, 206a, 305).

10. Circuit électrique comprenant un circuit oscillant selon l'une quelconque des revendications 1 à 8.
